# EUROPEAN PATENT SPECIFICATION

(11) **EP 2 301 064 B1**
(45) Date of publication and mention of the grant of the patent: **29.08.2018**
(21) Application number: 09761633.8
(22) Date of filing: 29.05.2009
(51) Int. Cl.: H01L 21/00, H01L 21/677

(54) **SHORT THERMAL PROFILE OVEN USEFUL FOR SCREEN PRINTING**
FÜR DEN SIEBDRUCK NÜTZLICHER OFEN MIT KURZEM THERMISCHEN PROFIL
FOUR À PROFIL THERMIQUE COURT UTILE POUR LA SÉRIGRAPHIE

(30) Priority: 11.06.2008 IT UD20080135; 27.06.2008 IT UD20080154; 29.09.2008 US 240955; 18.11.2008 US 273442
(43) Date of publication of application: 30.03.2011
(73) Proprietor: APPLIED MATERIALS ITALIA S.R.L., 31048 San Biagio di Callalta (TV) (IT)
(72) Inventor: BACCINI, Andrea, 31030 Mignagola di Carbonera (TV) (IT)
(74) Representative: Zimmermann & Partner Patentanwälte mbB
(86) International application number: PCT/EP2009/056663
(87) International publication number: WO 2009/150070

(56) References cited:
- EP-A1- 0 849 773
- WO-A-2006/069256
- US-A- 5 440 101
- US-A1- 2003 108 349
- US-A1- 2004 226 513
- US-A1- 2006 130 750

## Description

### BACKGROUND OF THE DISCLOSURE

### Field of the Invention

The present invention relates to a system used to deposit a patterned layer on a surface of a substrate, such as a screen printing process.

### Description of the Background Art

Solar cells are photovoltaic (PV) devices that convert sunlight directly into electrical power. PV devices typically have one or more p-n junctions. Each junction comprises two different regions within a semiconductor material where one side is denoted as the p-type region and the other as the n-type region. When the p-n junction of the PV cell is exposed to sunlight (consisting of energy from photons), the sunlight is directly converted to electricity through the PV effect. PV solar cells generate a specific amount of electric power and cells are tiled into modules sized to deliver the desired amount of system power. PV modules are joined into panels with specific frames and connectors. The solar cells are commonly formed on a silicon substrate, which may be in form of single or multicrystalline silicon substrates. A typical PV cell includes a p type silicon wafer, substrate or sheet typically less than about 0.3 mm thick with a thin layer of n-type silicon on top of a p-type region formed in a substrate.

The photovoltaic market has experienced growth with annual growth rates exceeding above 30% for the last ten years. Some articles have suggested that solar cell power production world wide may exceed 10 GWp in the near future. It has been estimated that more than 95% of all photovoltaic modules are silicon wafer based. The high market growth rate in combination with the need to substantially reduce solar electricity costs has resulted in a number of serious challenges for inexpensively forming high quality photovoltaic devices. Therefore, one major component in making commercially viable solar cells lies in reducing the manufacturing costs required to form the solar cells by improving the device yield, increasing the substrate throughput and/or reducing the energy consumed to produce the formed devices.

Screen printing has long been used in printing designs on objects, such as cloth, and is used in the electronics industry for printing electrical component designs, such as electrical contacts or interconnects on the surface of a substrate. State of the art solar cell fabrication processes also use screen printing processes.

Commonly, after depositing a pattern on a surface of a component it is desirable to dry the deposited material to assure that the deposited pattern is stable during subsequent transferring steps and is able to withstand the subsequent processing steps, such as high temperature annealing processes performed during solar cell production. Conventional radiant heating type drying processes used during solar cell manufacturing require a significant amount of time to perform and waste a significant amount of energy to complete, due to the typically low infrared (IR) absorption by the substrates.

Moreover, a solvent material is typically removed from the material deposited on the substrate surface during the drying process, which can contaminate the processed substrates and components in the drying device. Also, the vaporization rate of the solvent from the deposited material, and thus the time required to "dry" the deposited material can depend on the partial pressure of solvent material in the processing region of the drying device. Therefore, there is a need for a way to remove the vaporized solvent material and reduce the amount of vapor in the oven during processing to reduce contamination of the substrates and supporting hardware and speed up the drying process.

US 2006/130750 A1 describes an apparatus for processing substrates using a multichamber processing system, e.g., a cluster tool. The cluster tool is adapted to perform a track lithography process in which a substrate is coated with a photosensitive material, is then transferred to a stepper/scanner, which exposes the photosensitive material to some form of radiation to form a pattern in the photosensitive material, which is then removed in a developing process completed in the cluster tool.

EP 0 849 773 A1 describes a system for curing a die attach material for attachment of a semiconductor die to a leadframe which includes a carrier receiving location for receiving at least one carrier, wherein each carrier contains at least one leadframe strip therein, a die attach material on the leadframe strip and a semiconductor die on the die attach material. A heat source is provided for radiating thermal energy to the carrier receiving location. A reflector is disposed around the heat source and the carrier receiving location for reflecting thermal energy from the heat source to the carrier receiving location. A source of flowing cool gas is provided in heat exchange relationship with the reflector for cooling the reflector while heating the gas. The heated gas is passed through the carrier receiving location.

US 5 440 101 A describes a pass-through convection oven having a series of gas jet distributors and an exhaust system adjacent later distributors in the series to gather gas for the initial distributors in the series. A distributor in the series is formed of a pair of plenums in series in the gas flow path with a cumulative area of the passageway between them exceeding the cumulative area of the orifice from which the gas jets are formed in that distributor.

Therefore, there is also a need for a screen printing apparatus for the production of solar cells, electronic circuits or other useful devices that reduces the time it takes to dry the deposited material formed during a screen printed process, reduces energy consumption, improves the device yield and produce a lower cost of ownership (CoO) than other known apparatuses.

### SUMMARY OF THE INVENTION

The present invention as recited in independent claim 1 provides an apparatus for processing a substrate, comprising a first conveyor adapted to transfer one or more substrates through a processing region, a radiant heat transfer assembly that is adapted to deliver electromagnetic energy at one or more wavelengths to the one or more substrates positioned on the first conveyor, and a convective heat transfer assembly comprising a plenum having a resistive heating element disposed therein, and a fluid delivery device that is configured to move a gas past the resistive heating element disposed in the plenum, and past a surface of the substrate positioned on the first conveyor within the processing region, wherein the radiant heat transfer assembly and the convective heat transfer assembly are separately controlled so as to achieve a desired thermal profile.

The present invention as recited in independent claim 10 provides a method of processing a substrate, comprising positioning a substrate in a screen printing chamber and then depositing a material on the substrate using a screen printing process, transferring the substrate to a processing region of a drying chamber after depositing the material, delivering an amount of electromagnetic energy by a radiant heat transfer assembly to a surface of the substrate positioned in the processing region, and delivering a heated gas with a convective heat transfer assembly past the surface of the substrate positioned in the processing region, wherein the gas is heated by flowing the gas past a resistive heating element, and separately controlling the radiant heat transfer assembly and the convective heat transfer assembly so as to achieve a desired thermal profile.

Embodiments as described herein provide a method of processing a substrate, comprising depositing a patterned material on a surface of substrate, transferring the substrate to a conveyor after depositing the patterned material, transferring the substrate through at least a portion of a processing region of a drying chamber using the conveyor, delivering an amount of electromagnetic energy to a surface of the substrate as it is transferred through the processing region, and delivering a heated gas past the substrate as it is transferred through the processing region, wherein delivering the heated gas further comprises heating a gas by flowing the gas past a heating element, directing the heated gas through a region of the processing region and receiving at least a portion of the heated gas directed through the processing region, and delivering the at least a portion of the heated gas past the heat element to recirculate the portion of the heated gas.

Embodiments as described herein further provide an apparatus for processing a substrate, comprising a first conveyor adapted to transfer one or more substrates through a processing region, a radiant heat transfer assembly that is adapted to deliver electromagnetic energy at one or more wavelengths to the one or more substrates positioned on the first conveyor, and a convective heat transfer assembly comprising a plenum having a plurality of heat exchanging tubes and a heating element disposed therein, a fluid delivery device that is adapted move a gas across a first surface of the plurality of heat exchanging tubes and the heating element disposed in the plenum, and past a surface of the substrate positioned on the first conveyor within the processing region, a heat exchanging device that is adapted to control the temperature of the plurality of heat exchanging tubes, and a plenum inlet that is positioned to receive the gas moved past the surface of the substrate and direct the received gas past a second surface of the heat exchanging tubes.

Embodiments as described herein further provide a method of processing a substrate, comprising depositing a material on a surface of a substrate, transferring the substrate to a processing region of a drying chamber after depositing the material, delivering an amount of electromagnetic energy to a surface of the substrate positioned in the processing region, and delivering a heated gas to the substrate as it is transferred through the processing region, wherein delivering the heated gas further comprises heating a gas by flowing the gas past a heating element, directing the heated gas past the substrate positioned in the processing region, and receiving at least a portion of the heated gas directed past the substrate, and delivering the heated gas to a first heat exchanging surface to remove energy from the heated gas.

Embodiments as described herein further provide an apparatus for processing a substrate, comprising a rotary actuator assembly having a first rotational axis, a first substrate support that is coupled to the rotary actuator, a first conveyor that is adapted to transfer one or more substrates through a processing region, and is positioned to receive a substrate from the first substrate support when the rotary actuator is angularly positioned in a first orientation, a radiant heat transfer assembly that is adapted to deliver electromagnetic energy at one or more wavelengths to the one or more substrates positioned on the second conveyor, and a convective heat transfer assembly comprising a plenum having a plurality of heat exchanging tubes and a heating element disposed therein, a fluid delivery device that is adapted move a gas across a first surface of the plurality of heat exchanging tubes, the heating element, and a surface of each of the one or more substrates positioned in the processing region, a heat exchanging device that is adapted to control the temperature of the plurality of heat exchanging tubes, and a plenum inlet that is positioned to receive the gas moved past the surface of the one or more substrates and direct the received gas past a second surface of the plurality of heat exchanging tubes.

### BRIEF DESCRIPTION OF THE DRAWINGS

So that the manner in which the above recited features of the present invention are attained and can be understood in detail, a more particular description of the invention, briefly summarized above, may be had by reference to the embodiments thereof which are illustrated in the appended drawings.
Figure 1 is an isometric view of a screen printing system according to one embodiment of the invention.
Figures 2 is a plan view of the screen printing system illustrated in Figure 1 according to one embodiment of the invention.
Figure 3 is an isometric view of a rotary actuator assembly according to one embodiment of the invention.
Figure 4 is an isometric view of a printing nest portion of the screen printing system according to one embodiment of the invention.
Figure 5 is a side cross-sectional view of a drying chamber according to one embodiment of the invention.
Figure 6 is another side cross-sectional view of the drying chamber according to Figure 5.
Figure 7 is a side cross-sectional view of a drying chamber according to one embodiment of the invention.

To facilitate understanding, identical reference numerals have been used, where possible, to designate identical elements that are common to the figures. It is contemplated that elements and features of one embodiment may be beneficially incorporated in other embodiments without further recitation.

It is to be noted, however, that the appended drawings illustrate only exemplary embodiments of this invention and are therefore not to be considered limiting of its scope, for the invention may admit to other equally effective embodiments.

### DETAILED DESCRIPTION

The present invention(s) provide an apparatus and method for efficiently drying material deposited on a substrate surface. The apparatus and methods described herein may be useful for removing a solvent type material from a material deposited on a surface of a substrate. In some cases the material may be deposited using a screen printing process. In one embodiment, a screen printing chamber is adapted to deposit a patterned material on a crystalline silicon substrate and then dry the deposited material in a drying chamber. In one embodiment, the screen printing chamber and the drying chamber are both positioned within the Rotary line tool or the Softline™ tool available from Applied Materials Italia S.r.l., which is owned by Applied Materials, Inc. of Santa Clara, California.

### Screen Printing System

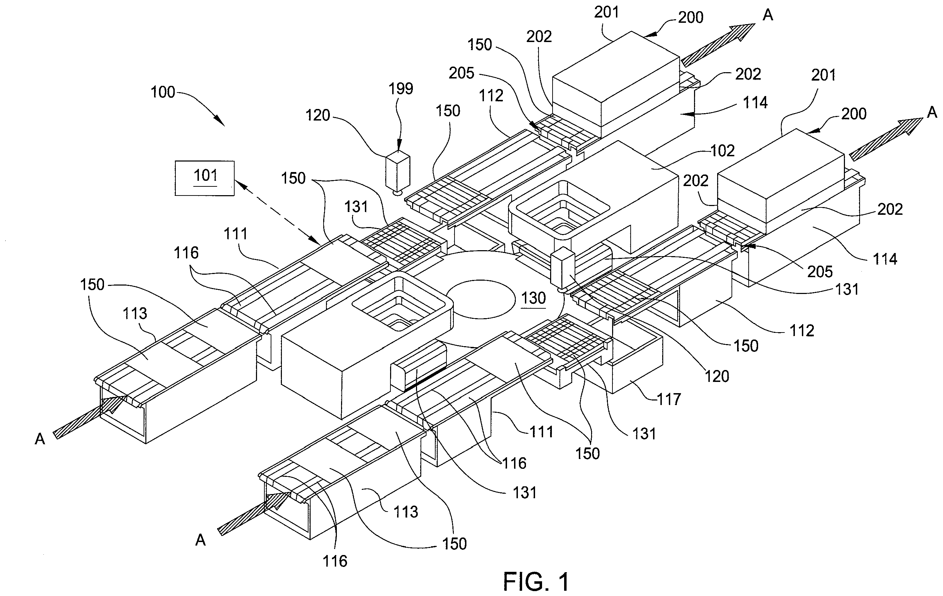

Figures 1-2 illustrate a multiple screen printing chamber processing system, or system 100, that may be used in conjunction with various embodiments of this invention. In one embodiment, the system 100 generally contains two incoming conveyors 111, a rotary actuator assembly 130, two screen printing heads 102, two outgoing conveyors 112 and two drying chambers 200. Each of the two incoming conveyors 111 are configured in a parallel processing configuration so that they each can receive substrates from an input device, such as an input conveyor 113, and transfer the substrate to a printing nest 131 coupled to the rotary actuator assembly 130. Also, each of the outgoing conveyors 112 are configured to receive processed substrates from the printing nest 131 coupled to the rotary actuator assembly 130 and transfer each processed substrate to the drying chamber 200. The input conveyor 113 and a drier conveyor 114, which is contained in the drying chamber 200, are generally automated substrate handling devices that are connected to a larger production line, for example the Rotary line tool or the Softline™ tool, that is connected to the system 100. While the drier conveyor 114, the incoming conveyors 111, the outgoing conveyors 112, and the input conveyors 113 are generally described below as a belt type conveyor, other types of conveyors, robotic devices, or other similar substrate transferring mechanisms could be used without varying from the basic scope of the invention described herein. One will note that Figures 1-4 are only intended to illustrate one possible processing system configuration that could benefit from the various embodiments described herein, and thus other conveyor configurations and other types of material deposition chambers could be used without deviating from the basic scope of the invention described herein.

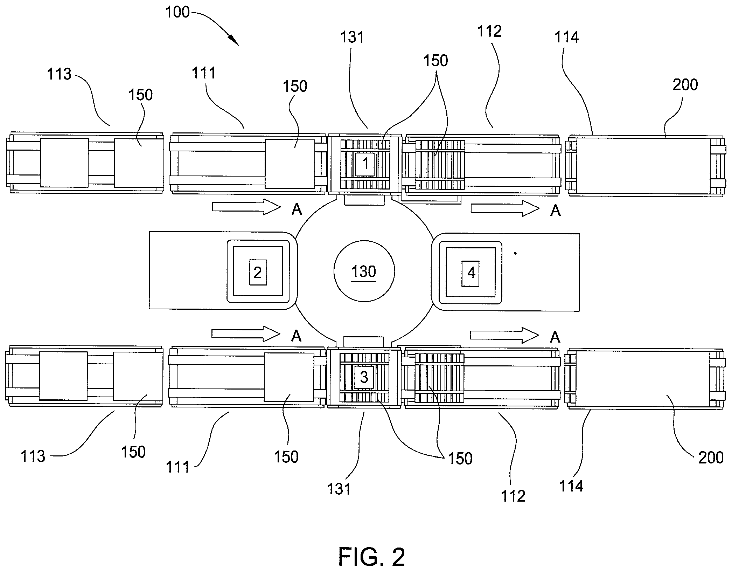

Figure 2 is a plan view of the system 100 that schematically illustrates the position of the rotary actuator assembly 130 in which two of the printing nests 131 (*e.g.,* reference numerals "1" and "3") are oriented so that they can transfer a substrate 150 from each of the printing nests 131 to the outgoing conveyor 112 and each receive a substrate 150 from each of the incoming conveyors 111. The substrate motion thus generally follows the path "A" shown in Figures 1 and 2. In this configuration the other two printing nests 131 (*e.g.,* reference numerals "2" and "4") are oriented so that a screen printing process can be performed on the substrates 150 that are positioned within the two screen printing chambers (*i.e*., screen printing heads 102 in Figure 1). Also, in this configuration, the printing nests 131 are oriented such that the direction of substrate movement on the nest is tangential to the rotary actuator assembly 130. A tangential orientation of the conveyors to the rotary actuator assembly 130 allows the substrates to be delivered and received from two locations, for example reference numerals "1" and "3" (Figure 2), without increasing the footprint of the system.

The incoming conveyor 111 and outgoing conveyor 112 generally include at least one belt 116 that is able to support and transport the substrates 150 to a desired position within the system 100 by use of an actuator (not shown) that is in communication with the system controller 101. While Figures 1-2 generally illustrate a two belt 116 style substrate transferring system, other types of transferring mechanisms may be used to perform the same substrate transferring and positioning function(s) without varying from the basic scope of the invention.

The system controller 101 is generally designed to facilitate the control and automation of the overall system 100 and typically may include a central processing unit (CPU) (not shown), memory (not shown), and support circuits (or I/O) (not shown). The CPU may be one of any form of computer processors that are used in industrial settings for controlling various chamber processes and hardware (*e.g.,* conveyors, detectors, motors, fluid delivery hardware, etc.) and monitor the system and chamber processes (*e.g.,* substrate position, process time, detector signal, etc.). The memory is connected to the CPU, and may be one or more of a readily available memory, such as random access memory (RAM), read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like. A program (or computer instructions) readable by the system controller 101 determines which tasks are performable on a substrate. Preferably, the program is software readable by the system controller 101, which includes code to generate and store at least substrate positional information, the sequence of movement of the various controlled components, substrate inspection system information, and any combination thereof.

The two screen print heads 102 utilized in the system 100 may be conventional screen printing heads available from Applied Materials Italia S.r.l. which are adapted to deposit material in a desired pattern on the surface of a substrate positioned on a printing nest 131 during the screen printing process. In one embodiment, the screen print heads 102 are adapted deposit a metal containing or dielectric containing material on a solar cell substrate. In one example, the substrate is a solar cell substrate that has a width between about 125 mm and 156 mm in size and a length between about 70 mm and 156 mm.

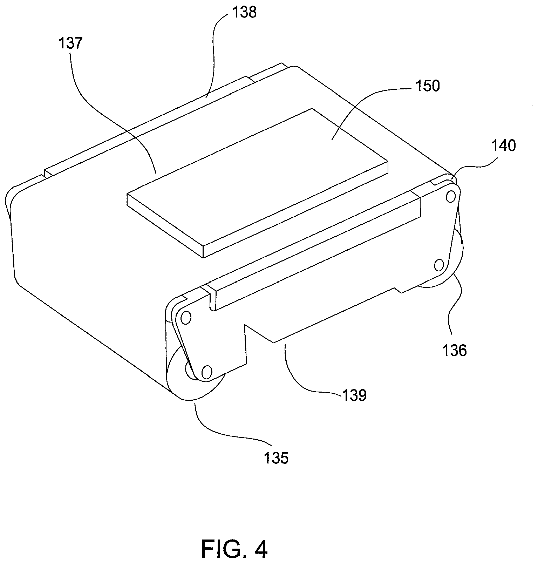

In one embodiment, the system 100 also contains an inspection assembly 199, which are adapted to inspect the substrates 150 before or after the screen printing process has been performed. The inspection assembly 199 may contain one or more cameras 120 that are positioned to inspect an incoming or processed substrate positioned in the positions "1" and "3," as shown in Figures 1 and 2. The inspection assembly 199 generally contains at least one camera 120 (e.g., CCD camera) and other electronic components that are able to inspect and communicate the inspection results to the system controller 101 so that damaged or mis-processed substrates can be removed from the production line. In one embodiment, the printing nests 131 may each contain a lamp, or other similar optical radiation device, to illuminate a substrate 150 positioned over the support platen 138 (Figure 4) so that it can be more easily inspected by an inspection assembly 199. If the substrate is damaged it can be moved to the waste collection bins 107 by use of the components in the support platen 138.

The inspection assembly 199 can also be used to determine the precise position of the substrates on each of the print nests 131. The location data of each substrate 150 on each printing nest 131 can be used by the system controller 101 to position and orient the screen print head components in the screen print head 102 to improve the accuracy of the subsequent screen printing process. In this case the position of each of the print heads can be automatically adjusted to align the screen print head 102 to the exact position of the substrate positioned on the print nest 131 based on the data received during inspection process step(s).

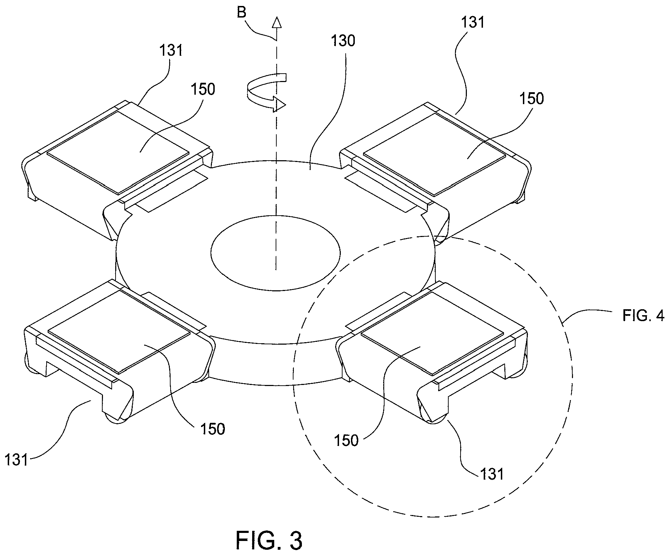

In one embodiment, as shown in Figures 1-3, the rotary actuator assembly 130 contains four printing nests 131 that are each adapted to support a substrate 150 during the screen printing process performed within each of the screen print heads 102. Figure 3 is an isometric view of the rotary actuator assembly 130 that illustrates a configuration in which a substrate 150 disposed on each of the four printing nests 131. The rotary actuator assembly 130 can be rotated and angularly positioned about the axis "B" by the use of a rotary actuator (not shown) and the system controller 101 so that the printing nests 131 can be desirably positioned within the system. The rotary actuator assembly 130 may also have one or more supporting components that facilitate the control of the printing nests 131 or other automated devices that are used to perform a substrate processing sequence in the system 100.

### Printing Nest Configuration

As illustrated in Figure 4, each printing nest 131 generally consist of a conveyor assembly 139 that has a feed spool 135, a take-up spool 136, and one or more actuators (not shown) that are coupled to the feed spool 135 and/or take-up spool 136, and are adapted to feed and retain a supporting material 137 positioned across a platen 138. The platen 138 generally has a substrate supporting surface on which the substrate 150 and supporting material 137 are positioned during the screen printing process performed in the screen print head 102. In one embodiment, the supporting material 137 is a porous material that allows a substrate 150, which is disposed on one side of the supporting material 137, to be retained on the platen 138 by a vacuum applied to the opposing side of the supporting material 137 by a conventional vacuum generating device (*e*.*g*., vacuum pump, vacuum ejector). In one embodiment, a vacuum is applied to vacuum ports (not shown) formed in the substrate supporting surface 138A of the platen 138 so that the substrate can be "chucked" to the substrate supporting surface 138A of the platen. In one embodiment, the supporting material 137 is a transpirable material that consists, for instance, of a transpirable paper of the type used for cigarettes or another analogous material or of a material which performs the same purpose.

In one configuration, a nest drive mechanism 148 that is coupled to, or is adapted to engage with, the feed spool 135 and a take-up spool 136 so that the movement of a substrate 150 positioned on the supporting material 137 can be accurately controlled within the printing nest 131. In one embodiment, feed spool 135 and the take-up spool 136 are each adapted to receive opposing ends of a length of the supporting material 137. In one embodiment, the nest drive mechanism 148 contains one or more drive wheels 147 that are coupled to, or in contact with, the surface of the supporting material 137 positioned on the feed spool 135 and/or the take-up spool 136 to control the motion and position of the supporting material 137 across the platen 138.

Referring to Figure 4, in one configuration the tension and motion of the supporting material 137 across the platen 138 is controlled by conventional actuators (not shown) that are able to control the rotational movement of the feed spool 135 and/or the take-up spool 136. In one configuration, the supporting material 137 is guided and supported by a plurality of pulleys 140 as it is moved in either direction between the feed spool 135 and the take-up spool 136.

### Drying Oven Configuration

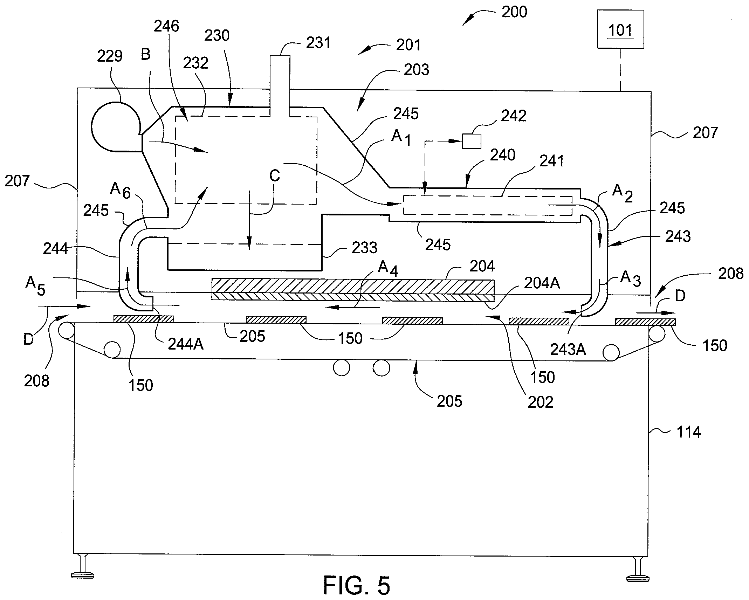

Figure 1 generally illustrates a system configuration that contains two drying chambers 200 that are each positioned to receive a substrate 150 from an outgoing conveyor 112, after the substrate 150 has been processed in a screen printing head 102. Figures 5-6 generally illustrate one or more embodiments of a drying chamber 200 which is further described below. In general, the drying chamber 200 contains a processing region 202 in which energy is delivered from a thermal system 201 to one or more substrates positioned therein, so that the material deposited on a surface of the one or more substrates can be dried. In one example, the deposited material is an aluminum (Al) containing paste, such as a lead free aluminum cermet paste (e.g., Al Cermet 6214) that are commonly used in solar cell production processes to form the backside contacts on a crystalline solar cell substrate. In another example, the deposited material may be a silver (Ag) paste used on the front side of a solar cell (*e.g.,* PV 156 made by DuPont™) or a silver-aluminum (Ag/AI) paste (PV202 from DuPont™) used on the back side of a solar cell. The processing region 202 has a drier conveyor 114 that is adapted to receive a substrate from another transferring device (*e.g.,* outgoing conveyor 112), and move and/or position the substrate 150 within the processing region 202.

Figure 5 is a side cross-sectional view of one embodiment of the thermal system 201 contained in the drying chamber 200. The thermal system 201 generally comprises a radiant heating assembly 204 and a convective heating assembly 203 that are used together to rapidly dry the material deposited on the surface of the substrate. In this configuration, convective and radiative heat transfer modes can be separately controlled to achieve a desired thermal profile (*e.g.,* temperature versus time) during the drying process to improve throughput and reduce energy consumption. In one embodiment, the substrate temperature during the drying process is raised to between about 150 °C and about 300 °C. In general, it is desirable not to exceed the temperature at which the binders in the deposited material break down (*e.g.,* 300-350°C) to prevent damage to the formed pattern on the substrate.

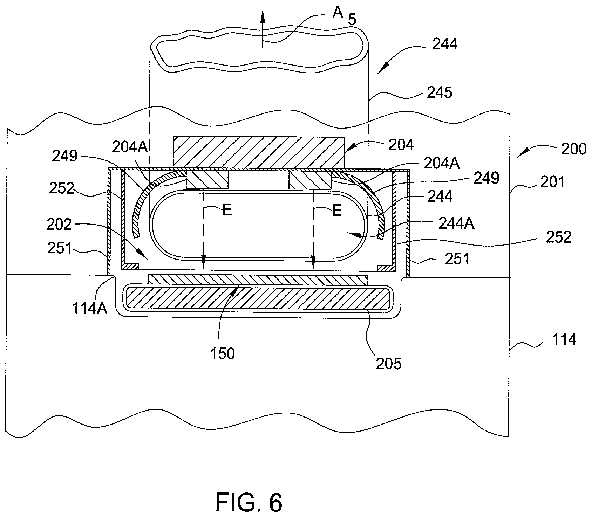

In one configuration, as shown in Figure 5, one or more substrates 150 are transferred through the processing region 202 following path "D" using the drier conveyor 114. The drier conveyor 114 is generally an automated substrate handling devices that is used to transfer and/or position one or more substrates through the processing region 202. In one embodiment, as shown in Figure 6, the drier conveyor 114 consist of a single belt 205 that is adapted to support a substrate 150 during processing in the processing region 202. In one configuration the belt 205 is a metal belt, a glass fiber impregnated belt, a ceramic material impregnated belt, or a metal impregnated belt, that is able to withstand the processing temperatures achieved in the processing region 202.

The radiant heating assembly 204 generally contains one or more electromagnetic energy delivering devices that are used to provide energy to the substrates positioned on the belt 205 as they pass through the processing region 202. In one embodiment, the electromagnetic energy delivering device comprises one or more lamps 204A (Figures 5 and 6) that are adapted to and/or selected to deliver radiation at one or more desirable wavelengths to the substrate 150. The wavelength(s) of the radiant energy delivered from the radiant heating assembly 204 is generally selected so that it is absorbed by the material deposited on the surface of the substrate. However, in cases where the thermal budget of the processed substrate is an issue, such as semiconductor substrates, solar cells, or other similar devices, it may be desirable to limit the wavelengths of the radiant energy delivered to substrate so that the radiant energy is preferentially absorbed by the deposited material and generally not by the material from which the substrate is made. In one example, in cases where the substrate is made from a silicon (Si) containing material the wavelength of the energy delivered by an lamps 204A may be adjusted or filtered so that only wavelengths greater than the absorption edge of silicon, which is generally about 1.06 (µm), are delivered to reduce the amount of energy absorbed by the silicon substrate.

In one embodiment, the optimal wavelengths delivered by the radiant heating assembly 204 are selected and/or adjusted for each type of substrate and each type of material deposited on a surface of the substrate to improve the absorption of the delivered energy, and thus the drying process of the deposited material. In one embodiment, the lamps 204A are infrared (IR) lamps that have a maximum operating temperature between about 1200 and 1800 °C and have a maximum power emission at wavelengths greater than about 1.4 µm. In one example, the lamps 204A are a double filament 5 kW fast medium wave IR lamp that is about 1 meter long, which is available from Heraeus Nobelight GmbH of Hanau, Germany. In some cases it is desirable to adjust the wavelength(s) of the emitted radiation from the lamps 204A by adjusting the power delivered to the lamps and thus the temperature of the filament within the lamp (e.g., Wien's law). Therefore, by use of the system controller 101, a power supply (not shown) coupled to the lamps 204A, and knowledge of the optical absorption characteristics of the deposited material on the surface of the substrate, the wavelengths of the delivered energy by the lamps 204A can be adjusted to improve the drying process.

Figure 6 illustrates one embodiment of the radiant heating assembly 204 that utilizes two lamps 204A that are positioned within and extend along a desired length of the processing region 202 (Figure 5). In this configuration, the lamps 204A are positioned to transfer energy (path "E") to one or more substrates positioned on the belt 205 in the processing region 202 as the one or more substrates are transferred the length of the lamp 204A during the drying process. In some cases it may be desirable to provide one or more reflectors 249 above the lamps 204A to reduce the amount of heat being transferred to other unwanted portions of the thermal system 201 and focus the energy towards the substrate 150. Also, in some cases the lamps 204A have a reflector disposed on one side of the lamp to reduce the amount of heat being transferred to other unwanted portions of the thermal system 201 and focus the energy towards the substrate 150.

The thermal system 201 also utilizes the convective heating assembly 203 to transfer heat to a substrate using a convective heat transfer method, such as delivering a heated gas (*e.g.,* air) across the surface of the substrate that is positioned in the processing region 202. Convective heat transfer methods will generally heat the substrate and deposited material at similar rates. In cases where the substrate conductivity is relatively high, such as silicon substrates, the temperature uniformity across the substrate will remain relatively uniform. The convective heat transfer rate can also be easily controlled by adjusting the flow rate and/or the temperature of the convective gas.

Referring to Figure 5, the convective heating assembly 203 generally comprises a fluid transferring device 229, a plenum 245 and a gas heating assembly 240. A substrate disposed in the processing region 202 is thus heated by directing the gas provided from the fluid transferring device 229 through the heating assembly 240 and past a surface of the substrate 150. In one embodiment, the fluid transferring device 229 is an AC fan that can deliver a desired flow rate of gas (see path "B") through the radiant heating assembly 204 and into the processing region 202.

The gas heating assembly 240 generally contains one or more resistive heating elements positioned in a heated zone 241 that is adapted heat the gas delivered from the fluid transferring device 229. The temperature of the gas exiting the gas heating assembly 240 may be controlled by use of a conventional heating element temperature controller 242, one or more conventional temperature sensing devices (not shown), resistive heating elements (not shown) positioned in the heating zone 241, and commands sent from the system controller 101. Generally, the power, size and length of the resistive heating elements positioned in the heating zone 241 will depend on flow rate of the delivered gas and the desired gas temperature to be achieved during the drying process. In one embodiment, the gas temperature at the exit of the gas heating assembly 240 is controlled to between about 150 °C and about 300 °C.

The plenum 245 is generally an enclosed region that is used to direct the gas delivered from fluid transferring device 229 through the gas heating assembly 240, into the plenum exit section 243 and then through the processing region 202. The plenum 245 may also contain a plenum inlet section 244 that is adapted to receive the gas transferred through the processing region 202 to provide a gas return, or re-circulation path, so that heated gas, such as air, can be collected and reused. The recirculation path thus generally follows the paths A₁-A₆, which passes through heat exchanging region 246, the heating assembly 240, the plenum exit section 243, the processing region 202, and the plenum inlet section 244, as shown in Figure 5. Recirculating the heated gas can dramatically help reduce the amount of energy required to heat the air to a desired temperature before at least a portion of it is redelivered into the processing region 202.

In one embodiment, the convective heating assembly 203 also contains a heat exchanging device 230 that is used to remove undesirable contaminants from the gas delivered by the fluid transferring device 229 and the recirculated gas received from the processing region 202 (reference numerals A₅-A₆). The heat exchanging device 230 may contain one or more heat exchanging surfaces 232 that are coupled to a thermal controller 231 and/or one or filtration type components that are adapted to remove possible contaminants from the gas passing through this section of the plenum 245. In general, the thermal controller 231 is adapted to keep the temperature of the heat exchanging surfaces 232 at a temperature below the temperature of the heated gas delivered to the processing region 202 to condense and remove any volatile components contained in the recirculated gas. The heat exchanging surfaces 232 can also be used to preheat the gas delivered to the gas heating assembly 240 from the fluid transferring device 229 (*i.e*., path "B"). Preheating the gas before it enters the gas heating assembly 240 may also help improve the gas heating efficiency and thus reduce the power consumption of the drying process performed in the drying chamber. Since energy consumption is often an important factor in the cost to produce a solar cell device, the methods of preheating and/or recirculating the gas discussed herein can help reduce the cost of ownership of a screen printing production line and thus the formed device's production cost.

Typically, the recirculated gas will contain an amount of one or more volatile components that are entrained in the recirculating gas due to the vaporization of volatile components escaping from the deposited material during the drying process. By maintaining the heat exchanging surfaces 232 at a temperature below the condensation point of the volatile components, the volatile components will condense and be removed from the recirculated gas. Trapping the volatile components in the heat exchanging device 230 may also help reduce the contamination of the substrates and plenum 245 components by the recirculated gas. In one example, the temperature of the heat exchanging surfaces 232 are maintained at a temperature of <219 °C to remove any organic solvents, such as terpinol or esters. In one embodiment, the heat exchanging surfaces 232 are maintained at a temperature between about 40 °C and about 80 °C to condense the vapor material entrained in the recirculated gas. The temperature of the heat exchanging surfaces 232 may be controlled by use of the system controller 101 and the thermal controller 231, such as a conventional recirculating fluid type or a thermoelectric type heat exchanging device. Also, due to gravity the volatile components that condense on the heat exchanging surfaces 232 can flow to (*i.e*., path "C") and be collected within a fluid collection region 233 of the plenum 245. The fluid collection region 233 may contain one or more drains that are used to deliver the collected vapor material to a waste collection system (not shown).

Moreover, it is believed that using the heat exchanging device 230 to collect any volatile components entrained in the gas will also help to reduce the partial pressure of the vapor in the portion of the gas that passes through the processing region 202 a second time, thus allowing the flowing gas to receive a greater amount of the solvent material evaporating from the deposited material than would be allowed if a significant residual amount of the vapor was retained in the recirculated gas. Therefore, the time required to complete the drying process can be reduced by increasing the amount of solvent material received in the gas the flowing past the substrates.

Figure 6 illustrates side cross-sectional view of the processing region 202 which is perpendicular to the view illustrated in Figure 5 and is facing the direction A₄. As shown in Figure 6, the processing region 202 is partially enclosed by one or more walls, such as wall 251 of the thermal system 201 and wall 114A of the drier conveyor 114 so that most of the heated gas delivered by the convective heating assembly 203 and heat provided by the radiant heating assembly 204 is not lost. Referring to Figure 5, in one embodiment, the thermal system 201 and processing region 202 are at least partially enclosed by one or more walls 207. In one configuration, the walls 207 have small openings 208 at the opposing ends of the processing region 202 to allow substrates to be transferred in and out of the processing region 202 by use of the belt 205, while minimizing the amount of heated gas exiting the drying chamber 200. Partially enclosing the processing region 202 may also help to prevent any contaminants found in the gas flowing through the processing region 202 from contaminating any adjacent processing chambers.

In one embodiment, an inner shield 252 is used to further direct the flowing gas provided from the exit port 243A of the plenum exit section 243 (Figure 5) across the substrate 150 positioned in the processing region 202 and to the input port 244A of the plenum inlet section 244. The inner shield 252 may also be used to reflect and further direct any heat provided by the radiant heating assembly 204 to the substrate 150 positioned on the belt 205.

By adjusting the heat provided by the convective heating assembly 203 and the radiant heating assembly 204 the drying process can be adjusted and/or optimized to improve the drying time of the deposited material and reduce any possible thermal budget problems that may arise in the drying process. In one embodiment, as shown in Figure 5 a convective gas flow is delivered in a direction (*i.e*., direction A₄) opposite to the motion of the substrates 150 (*i.e*., direction "D") through the processing region 202 to preheat to the incoming substrates and improve the temperature ramp up rate. Moreover, since silicon substrates have a low absorption coefficient within the IR wavelengths the heat transfer efficiency and thus the time required to dry the substrate can be greatly reduced by use of the combination of convective heat transfer and radiant heat transfer modes. Due to the increased heat transfer efficiency the thermal profile of each dried substrate can be improved, since higher process temperatures can be more easily achieved.

It also is believed that the use of the methods described herein can also reduce the need for buffering devices typically used in conventional screen printing processes to assure that deposited material is dry, since the cycle time in conventional radiant only drying processes are often too inefficient and too long to keep up with the throughput of the rest of the production line. It is believed that use of the convective heat transfer and the wave length controlled radiant heating the substrate heating cycle within each drying chamber 200 will be reduced so that the drying oven throughput can exceed 1400 crystalline silicon 156 mm x 156 mm substrates per hour in a system that is less than about 2 meters long. It is believed that the rapid thermal processing methods described herein can thus reduces the cycle time, reduce the floor space taken up by the drying chamber 200 and reduce the CoO required to dry the substrates.

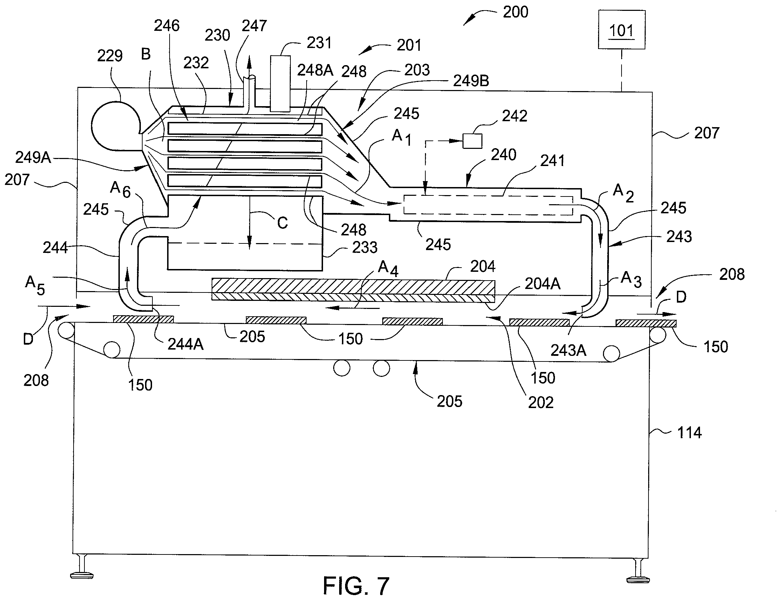

Figure 7 is a side cross-sectional view of an alternate embodiment of the thermal system 201 illustrated in Figures 5 and 6 in which the gas returning from the processing region 202 (*i.e*., paths A₅ and A₆) is not recirculated. In this configuration, the gas exiting the fluid transferring device 229 (e.g., path "B") enters an inlet plenum 249A passes through a plurality of heat exchanging tubes 248 and enters the exit plenum 249B before it is delivered through the gas heating assembly 240 and processing region 202. The heat exchanging tubes 248 are generally sealed so that the gas following path "B" passes through an internal region 248A of the tube and does not mix with the gas returning from the processing region 202. In one configuration, the gas returning from the processing region 202 along paths A₅ and A₆ passes by the external surfaces of the heat exchanging tubes 248 before it is exhausted from the thermal system 201 through a port 247. Therefore, by controlling the temperature of the heat exchanging tubes 248 using the thermal controller 231, the temperature of the gas flowing from the fluid transferring device 229 to the gas heating assembly 240 can be preheated, and the gas returning from the processing region 202 can be cooled to remove any entrained volatile components. In general, the thermal controller 231 is adapted to keep the temperature of the surfaces of the heat exchanging tubes 248 (*i.e*., heat exchanging surfaces 232) at a temperature below the temperature of the heated gas delivered to the processing region 202 to condense and remove any volatile components contained in the gas flowing along path A₆. Due to gravity the volatile components that condense on the heat exchanging tubes 248 will flow to (*i.e*., path "C") and be collected within a fluid collection region 233 of the plenum 245. The fluid collection region 233 may contain one or more drains that are used to deliver the collected vapor material to a waste collection system (not shown).

While the foregoing is directed to embodiments of the present invention, other and further embodiments of the invention may be devised without departing from the basic scope thereof, and the scope thereof is determined by the claims that follow.

## Claims

1. An apparatus for processing a substrate (150), comprising:
a first conveyor (111) configured to transfer one or more substrates (150) through a processing region (202);
a radiant heat transfer assembly (201) that is adapted to deliver electromagnetic energy at one or more wavelengths to the one or more substrates (150) positioned on the first conveyor (111); and
a convective heat transfer assembly (203) comprising:
a plenum (245) having a resistive heating element (240) disposed therein; and
a fluid delivery device (229) that is configured to move a gas past the resistive heating element (240) disposed in the plenum (245), and past a surface of the substrate (150) positioned on the first conveyor (111) within the processing region (202),
wherein the radiant heat transfer assembly (201) and the convective heat transfer assembly (203) are separately controlled so as to achieve a desired thermal profile.

2. The apparatus of claim 1, wherein the convective heat transfer assembly (203) further comprises:
the plenum (245) having an inlet port (244) that is positioned to receive the gas moved past the surface of the substrate (150); and
a heat exchanging assembly (230) having a heat exchanging surface (232) that is in fluid communication with the gas received through the inlet port (244).

3. The apparatus of claim 2, wherein the heat exchanging assembly (230) further comprises a thermal controller (231) that is in thermal communication with the heat exchanging surface (232) and is adapted to remove heat from the gas received through the inlet port (244).

4. The apparatus of claim 2, further comprising:
one or more walls (251) that partially enclose the first conveyor (111) and the processing region (202);
the plenum (245) further comprising an exit port (243) that is positioned between the resistive heating element (240) and the processing region (202), wherein the gas delivered by the fluid delivery device (229) is adapted to flow through the exit port (243) and between the one or more walls (251) that partially enclose the processing region (202) before entering the inlet port (244).

5. The apparatus of claim 1, further comprising:
the radiant heat transfer assembly (201) having one or more lamps (204A) and a power supply electrically coupled to the lamps (204A); and
a controller adapted to adjust the wavelength of electromagnetic energy delivered by the lamps (204A) to the substrate (150).

6. The apparatus of claim 4, wherein the conveyor (111) comprises a belt (116) that is adapted to transfer a substrate (150) through the processing region (202) and past the inlet port (244) and exit port (243).

7. The apparatus of claim 1, further comprising:
a first substrate support (131) that is coupled to a rotary actuator (130);
a first screen printing chamber (102) that is positioned to receive the first substrate support (131) when the rotary actuator (130) is angularly positioned in a first orientation; and
a second conveyor (112) that is positioned to transfer a substrate (150) from the first substrate support (131) when the rotary actuator (130) is angularly positioned in a second orientation, wherein the second conveyor (112) is in transferrable communication with the first conveyor (111).

8. The apparatus of claim 7, further comprising:
a second substrate support that is coupled to the rotary actuator (130);
a third conveyor that is positioned to transfer a substrate (150) to the second substrate support when the rotary actuator (130) is angularly positioned in the first orientation; and
a fourth conveyor that is positioned to receive a substrate (150) from the second substrate support when the rotary actuator (130) is angularly positioned in the first orientation.

9. The apparatus of claim 1, wherein the convective heat transfer assembly (203) further comprises:
a plurality of heat exchanging tubes (248) disposed within the plenum (245), wherein the fluid delivery device (229) is adapted to move a gas across a first surface of the plurality of heat exchanging tubes (248), the resistive heating element (240), and a surface of each of the one or more substrates (150) positioned in the processing region (202);
a heat exchanging device (230) that is adapted to control the temperature of the plurality of heat exchanging tubes (248); and
a plenum inlet that is positioned to receive the gas moved past the surface of the one or more substrates (150) and direct the received gas past a second surface of the plurality of heat exchanging tubes (248).

10. A method of processing a substrate (150), comprising:
positioning a substrate (150) in a screen printing chamber (102) and then depositing a material on the substrate (150) using a screen printing process;
transferring the substrate (150) to a processing region (202) of a drying chamber (200) after depositing the material;
delivering an amount of electromagnetic energy by a radiant heat transfer assembly (201) to a surface of the substrate (150) positioned in the processing region (202);
delivering a heated gas with a convective heat transfer assembly (203) past the surface of the substrate (150) positioned in the processing region (202), wherein the gas is heated by flowing the gas past a resistive heating element (240); and
separately controlling the radiant heat transfer assembly (201) and the convective heat transfer assembly (203) so as to achieve a desired thermal profile.

11. The method of claim 10, wherein delivering the amount of electromagnetic energy further comprises providing the electromagnetic energy at one or more desired wavelengths to promote the absorption of the electromagnetic energy by the deposited material, while minimizing the amount of energy absorbed by one or more materials contained in the substrate (150).

12. The method of claim 10, wherein delivering a heated gas further comprises:
controlling the temperature of a heat exchanging surface (232); and
delivering at least a portion of the heated gas after it was delivered past the substrate (150) to the heat exchanging surface (232), wherein the temperature of the heat exchanging surface (232) is controlled so that a volatile component contained in the portion of the heated gas condenses on the heat exchanging surface (232).

13. The method of claim 12, wherein the temperature of the first heat exchanging surface (232) is between about 40°C and about 300°C.

14. The method of claim 10, wherein delivering a heated gas further comprises:
directing the heated gas through a region of the processing region (202); and
receiving at least a portion of the heated gas directed through the processing region (202), and delivering the at least a portion of the heated gas past the resistive heating element (240) to recirculate the portion of the heated gas.

15. The method of claim 10, wherein the substrate (150) is a silicon containing substrate.

## Patentansprüche

1. Vorrichtung zum Bearbeiten eines Substrats (150), Folgendes umfassend:
ein erstes Fördermittel (111), das dafür konfiguriert ist, ein oder mehrere Substrate (150) durch einen Bearbeitungsbereich (202) zu überführen,
eine Strahlungswärme-Übertragungsanordnung (201), die dafür eingerichtet ist, elektromagnetische Energie mit einer oder mehreren Wellenlängen auf das eine oder die mehreren Substrate (150) zu führen, die auf dem ersten Fördermittel (111) positioniert sind, und
eine Konvektionswärme-Übertragungsanordnung (203), Folgendes umfassend:
ein Verteilerkanal (245) mit einem darin angeordneten Widerstandsheizelement (240) und
eine Fluidzufuhreinrichtung (229), die dafür konfiguriert ist, ein Gas vorbei am Widerstandsheizelement (240), das in dem Verteilerkanal (245) angeordnet ist, und vorbei an einer Oberfläche des Substrats (150), das auf dem ersten Fördermittel (111) positioniert ist, in den Bearbeitungsbereich (202) zu bewegen,
wobei die Strahlungswärme-Übertragungsanordnung (201) und die Konvektionswärme-Übertragungsanordnung (203) getrennt gesteuert werden, so dass ein gewünschtes Wärmeprofil erzielt wird.

2. Vorrichtung nach Anspruch 1, wobei die Konvektionswärme-Übertragungsanordnung (203) ferner Folgendes umfasst:
das Verteilerkanal (245) mit einem Einlassanschluss (244), der dafür positioniert ist, das Gas zu empfangen, das an der Oberfläche des Substrats (150) vorbei bewegt wird, und
eine Wärmetauschanordnung (230) mit einer Wärmetauschfläche (232), die in strömungstechnischer Verbindungmit dem Gas steht, das über den Einlassanschluss (244) empfangen wird.

3. Vorrichtung nach Anspruch 2, wobei die Wärmetauschanordnung (230) ferner eine Wärmesteuerung (231) umfasst, die in thermischer Verbindung mit der Wärmetauschfläche (232) steht und dafür eingerichtet ist, Wärme aus dem Gas zu entfernen, das über den Einlassanschluss (244) empfangen wird.

4. Vorrichtung nach Anspruch 2, ferner Folgendes umfassend:
eine oder mehrere Wände (251), die das erste Fördermittel (111) und den Bearbeitungsbereich (202) teilweise umschließen,
wobei das Verteilerkanal (245) ferner einen Auslassanschluss (243) umfasst, der zwischen dem Widerstandsheizelement (240) und dem Bearbeitungsbereich (202) positioniert ist, wobei das Gas, das von der Fluidzufuhreinrichtung (229) zugeführt wird, dafür eingerichtet ist, durch den Auslassanschluss (243) und zwischen der einen oder den mehreren Wänden (251) zu strömen, welche den Bearbeitungsbereich (202) teilweise umschließen, bevor es in den Einlassanschluss (244) eintritt.

5. Vorrichtung nach Anspruch 1, ferner Folgendes umfassend:
die Strahlungswärme-Übertragungsanordnung (201) mit einer oder mehreren Lampen (204A) und einer Energieversorgung, die mit den Lampen (204A) elektrisch verbunden ist, und
eine Steuerung, die dafür eingerichtet ist, die Wellenlänge der elektromagnetischen Energie zu justieren, die dem Substrat von den Lampen (204A) (150) zugeführt wird.

6. Vorrichtung nach Anspruch 4, wobei das Fördermittel (111) ein Band (116) umfasst, das dafür eingerichtet ist, ein Substrat (150) durch den Bearbeitungsbereich (202) und am Einlassanschluss (244) und am Auslassanschluss (243) vorbei zu überführen.

7. Vorrichtung nach Anspruch 1, Folgendes umfassend:
einen ersten Substratträger (131), der mit einem Drehantrieb (130) gekoppelt ist,
eine erste Siebdruckkammer (102), die dafür positioniert ist, den ersten Substratträger (131) zu empfangen, wenn der Drehantrieb (130) winklig in einer ersten Ausrichtung positioniert ist, und
ein zweites Fördermittel (112), das dafür positioniert ist, ein Substrat (150) vom ersten Substratträger (131) zu überführen, wenn der Drehantrieb (130) winklig in einer zweiten Ausrichtung positioniert ist, wobei das zweite Fördermittel (112) in Überführungstechnischer Verbindung mit dem ersten Fördermittel (111) steht.

8. Vorrichtung nach Anspruch 7, ferner Folgendes umfassend:
einen zweiten Substratträger, der mit dem Drehantrieb (130) gekoppelt ist,
ein drittes Fördermittel, das dafür positioniert ist, ein Substrat (150) zum zweiten Substratträger zu überführen, wenn der Drehantrieb (130) winklig in der ersten Ausrichtung positioniert ist, und
ein viertes Fördermittel, das dafür positioniert ist, ein Substrat (150) vom zweiten Substratträger zu empfangen, wenn der Drehantrieb (130) winklig in der ersten Ausrichtung positioniert ist.

9. Vorrichtung nach Anspruch 1, wobei die Konvektionswärme-Übertragungsanordnung (203) ferner Folgendes umfasst:
mehrere Wärmetauschrohre (248), die in dem Verteilerkanal (245) angeordnet sind, wobei die Fluidzufuhreinrichtung (229) dafür eingerichtet ist, ein Gas über eine erste Oberfläche der mehreren Wärmetauschrohre (248), das Widerstandsheizelement (240) und eine Oberfläche von jedem des einen oder der mehreren Substrate (150) zu bewegen, die im Bearbeitungsbereich (202) angeordnet sind,
eine Wärmetauscheinrichtung (230), die dafür eingerichtet ist, die Temperatur der mehreren Wärmetauschrohre (248) zu steuern; und
einen Verteilerkanaleinlass, der dafür positioniert ist, das Gas zu empfangen, das an der Oberfläche des einen oder der mehreren Substrate (150) vorbei bewegt wird, und das empfangene Gas an einer zweiten Oberfläche der mehreren Wärmetauschrohre (248) vorbeizuleiten.

10. Verfahren zum Bearbeiten eines Substrats (150), Folgendes umfassend:
Positionieren eines Substrats (150) in einer Siebdruckkammer (102) und dann Aufbringen eines Materials auf dem Substrat (150) mit Hilfe eines Siebdruckprozesses;
Überführen des Substrats (150) zu einem Bearbeitungsbereich (202) einer Trocknungskammer (200) nach dem Aufbringen des Materials;
Führen einer Menge elektromagnetischer Energie durch eine Strahlungswärme-Übertragungsanordnung (201) zu einer Oberfläche des Substrats (150), das im Bearbeitungsbereich (202) positioniert ist;
Führen von erwärmtem Gas mit einer Konvektionswärme-Übertragungsanordnung (203) vorbei an der Oberfläche des Substrats (150), das im Bearbeitungsbereich (202) positioniert ist, wobei das Gas erwärmt wird, indem es an einem Widerstandsheizelement (240) vorbeiströmt; und
getrenntes Steuern der Strahlungswärme-Übertragungsanordnung (201) und der Konvektionswärme-Übertragungsanordnung (203), so dass ein gewünschtes Wärmeprofil erzielt wird.

11. Verfahren nach Anspruch 10, wobei das Zuführen der Menge elektromagnetischer Energie ferner das Bereitstellen der elektromagnetischen Energie mit einer oder mehreren gewünschten Wellenlängen umfasst, um die Aufnahme der elektromagnetischen Energie durch das abgeschiedene Material zu fördern, während die Wärmemenge minimiert wird, die durch ein oder mehrere Materialien aufgenommen wird, die im Substrat (150) enthalten sind.

12. Verfahren nach Anspruch 10, wobei das Zuführen eines erwärmten Gases ferner Folgendes umfasst:
Steuern der Temperatur der Wärmetauschfläche (232) und Zuführen von mindestens einem Teil des erwärmten Gases, nachdem es am Substrat (150) vorbei zur Wärmetauschfläche (232) geführt wurde, wobei die Temperatur der Wärmetauschfläche (232) derart gesteuert wird, dass eine flüchtige Komponente, die in dem Teil des erwärmten Gases enthalten ist, an der Wärmetauschfläche (232) kondensiert.

13. Verfahren nach Anspruch 12, wobei die Temperatur der ersten Wärmetauschfläche (232) zwischen etwa 40 und etwa 300 °C liegt.

14. Verfahren nach Anspruch 10, wobei das Zuführen des erwärmten Gases ferner Folgendes umfasst:
Leiten des erwärmten Gases durch einen Bereich des Bearbeitungsbereiches (202); und
Empfangen mindestens eines Teils des erwärmten Gases, das durch den Bearbeitungsbereich (202) geleitet wird, und Führen des mindestens einen Teils des erwärmten Gases vorbei am Widerstandsheizelement (240), um den Teil des erwärmten Gases rückzuführen.

15. Verfahren nach Anspruch 10, wobei das Substrat (150) ein siliziumhaltiges Substrat ist.

## Revendications

1. Appareil pour traiter un substrat (150), comprenant :
un premier convoyeur (111) configuré pour transférer un ou plusieurs substrats (150) à travers une zone de traitement (202) ;
un ensemble de transfert de chaleur radiant (201) qui est adapté pour délivrer de l'énergie électromagnétique à une ou plusieurs longueurs d'onde au ou aux substrats (150) positionnés sur le premier convoyeur (111) ; et
un ensemble de transfert de chaleur convectif (203) comprenant :
un plénum (245) ayant un élément chauffant résistif (240) disposé dans celui-ci ; et
un dispositif de distribution de fluide (229) qui est configuré pour déplacer un gaz devant l'élément chauffant résistif (240) disposé dans le plénum (245), et devant une surface du substrat (150) positionné sur le premier convoyeur (111) à l'intérieur de la zone de traitement (202),
dans lequel l'ensemble de transfert de chaleur radiant (201) et l' ensemble de transfert de chaleur convectif (203) sont commandés séparément de manière à obtenir un profil thermique voulu.

2. Appareil selon la revendication 1, dans lequel l' ensemble de transfert de chaleur convectif (203) comprend en outre :
le plénum (245) ayant un orifice d'entrée (244) qui est positionné pour recevoir le gaz déplacé après la surface du substrat (150) ; et
un ensemble d'échange de chaleur (230) ayant une surface d'échange de chaleur (232) qui est en communication fluidique avec le gaz reçu à travers l'orifice d'entrée (244).

3. Appareil selon la revendication 2, dans lequel l'ensemble d'échange de chaleur (230) comprend en outre un contrôleur thermique (231) qui est en communication thermique avec la surface d'échange de chaleur (232) et est adapté pour prélever de la chaleur à partir du gaz reçu à travers l'orifice d'entrée (244).

4. Appareil selon la revendication 2, comprenant en outre :
une ou plusieurs parois (251) qui entourent partiellement le premier convoyeur (111) et la zone de traitement (202) ;
le plénum (245) comprenant en outre un orifice de sortie (243) qui est positionné entre l'élément chauffant résistif (240) et la zone de traitement (202), dans lequel le gaz distribué par le dispositif de distribution de fluide (229) est adapté pour s'écouler à travers l'orifice de sortie (243) et entre la ou les parois (251) qui entourent partiellement la zone de traitement (202) avant d'entrer dans l'orifice d'entrée (244).

5. Appareil selon la revendication 1, comprenant en outre :
l'ensemble de transfert de chaleur radiant (201) ayant une ou plusieurs lampes (204A) et une alimentation en courant électriquement couplée aux lampes (204A) ; et
un contrôleur adapté pour régler la longueur d'onde de l'énergie électromagnétique délivrée par les lampes (204A) au substrat (150).

6. Appareil selon la revendication 4, dans lequel le convoyeur (111) comprend une bande (116) qui est adaptée pour transférer un substrat (150) à travers la zone de traitement (202) et devant l'orifice d'entrée (244) et l'orifice de sortie (243).

7. Appareil selon la revendication 1, comprenant en outre :
un premier support de substrat (131) qui est couplé à un actionneur rotatif (130) ;
une première chambre de sérigraphie (102) qui est positionnée pour recevoir le premier support de substrat (131) lorsque l'actionneur rotatif (130) est positionné angulairement dans une première orientation ; et
un deuxième convoyeur (112) qui est positionné pour transférer un substrat (150) à partir du premier support de substrat (131) lorsque l'actionneur rotatif (130) est positionné angulairement dans une seconde orientation, dans lequel le deuxième convoyeur (112) est en communication transférable avec le premier convoyeur (111).

8. Appareil selon la revendication 7, comprenant en outre :
un second support de substrat qui est couplé à l'actionneur rotatif (130) ;
un troisième convoyeur qui est positionné pour transférer un substrat (150) vers le second support de substrat lorsque l'actionneur rotatif (130) est positionné angulairement dans la première orientation ; et
un quatrième convoyeur qui est positionné pour recevoir un substrat (150) provenant du second support de substrat lorsque l'actionneur rotatif (130) est positionné angulairement dans la première orientation.

9. Appareil selon la revendication 1, dans lequel l' ensemble de transfert de chaleur convectif (203) comprend en outre :
une pluralité de tubes d'échange de chaleur (248) disposés à l'intérieur du plénum (245), dans lequel le dispositif de distribution de fluide (229) est adapté pour déplacer un gaz à travers une première surface de la pluralité de tubes d'échange de chaleur (248), l'élément chauffant résistif (240) et une surface de chacun du ou des substrats (150) positionnés dans la zone de traitement (202) ;
un dispositif d'échange de chaleur (230) qui est adapté pour commander la température de la pluralité de tubes d'échange de chaleur (248) ; et
une entrée de plénum qui est positionnée pour recevoir le gaz déplacé devant la surface du ou des substrats (150) et diriger le gaz reçu devant une seconde surface de la pluralité de tubes d'échange de chaleur (248).

10. Procédé de traitement d'un substrat (150), comprenant :
positionner un substrat (150) dans une chambre de sérigraphie (102) et déposer ensuite un matériau sur le substrat (150) en utilisant un processus de sérigraphie ;
transférer le substrat (150) vers une zone de traitement (202) d'une chambre de séchage (200) après dépôt du matériau ;
fournir une quantité d'énergie électromagnétique par un ensemble de transfert de chaleur radiant (201) à une surface du substrat (150) positionné dans la zone de traitement (202) ;
fournir un gaz chauffé avec un ensemble de transfert de chaleur convectif (203) devant la surface du substrat (150) positionné dans la zone de traitement (202), dans lequel le gaz est chauffé en faisant couler le gaz devant un élément chauffant résistif (240) ; et
commander séparément l'ensemble de transfert de chaleur radiant (201) et l' ensemble de transfert de chaleur convectif (203) de manière à obtenir un profil thermique voulu.

11. Procédé selon la revendication 10, dans lequel la fourniture de la quantité d'énergie électromagnétique comprend en outre de fournir l'énergie électromagnétique à une ou plusieurs longueurs d'onde voulues pour favoriser l'absorption de l'énergie électromagnétique par le matériau déposé, tout en minimisant la quantité d'énergie absorbée par un ou plusieurs matériaux contenus dans le substrat (150).

12. Procédé selon la revendication 10, dans lequel la distribution d'un gaz chauffé comprend en outre :
commander la température d'une surface d'échange de chaleur (232) ; et
fournir au moins une partie du gaz chauffé après qu'il a été distribué devant le substrat (150) à la surface d'échange de chaleur (232), dans lequel la température de la surface d'échange de chaleur (232) est commandée de sorte qu'un composant volatile contenu dans la partie du gaz chauffé se condense sur la surface d'échange de chaleur (232).

13. Procédé selon la revendication 12, dans lequel la température de la première surface d'échange de chaleur (232) est entre environ 40 °C et environ 300 °C.

14. Procédé selon la revendication 10, dans lequel la distribution d'un gaz chauffé comprend en outre :
diriger le gaz chauffé à travers une zone de la zone de traitement (202) ; et
recevoir au moins une partie du gaz chauffé dirigé à travers la zone de traitement (202), et délivrer la au moins une partie du gaz chauffé devant l'élément chauffant résistif (240) pour remettre en circulation la partie du gaz chauffé.

15. Procédé selon la revendication 10, dans lequel le substrat (150) est un substrat contenant du silicium.
